# EUROPEAN PATENT APPLICATION

(11) **EP 4 148 410 A1**
(43) Date of publication of application: **15.03.2023**
(21) Application number: 21893113.7
(22) Date of filing: 13.07.2021
(51) Int. Cl.: G01N 1/28

(54) **TSV PRODUCT, TSV SAMPLE AND PREPARATION METHOD THEREFOR**

(30) Priority: 05.07.2021 CN 202110755788
(71) Applicant: Changxin Memory Technologies, Inc., Hefei City, Anhui 230000 (CN)
(72) Inventor: CHEN, Jiabao, Hefei Anhui 230000 (CN)
(74) Representative: Lavoix
(86) International application number: PCT/CN2021/106009
(87) International publication number: WO 2023/279415

(57) **Abstract**

This disclosure relates to the technical field of manufacturing process of semiconductor devices, and in particular to a Through-Silicon Via (TSV) product, a TSV sample, and a method for manufacturing the same. The method includes operations as follows. A first metal layer is deposited on a bottom of each of TSVs, the first metal layer covering the bottom of the TSV Pre-prepared adhesive is filled on an inner wall in a middle of each of TSVs of a to-be-processed sample. A second metal layer is deposited on a top of each of the TSVs, the second metal layer covering on the top of an opening of the TSV A capping layer is deposited on the second metal layer, to obtain a preprocessed to-be-processed sample. The preprocessed to-be-processed sample is cut in a preset cutting manner by using a dual-beam Plasma Focused Ion Beam (PFIB), to form a TSV sample with a cross-section of each of the TSVs is exposed. In this way, a curtain effect and a recessed site surface of the TSV sample due to the irradiation of an I-Beam can be prevented, thereby improving the accuracy of measuring size parameters of a TSV

## Description

### CROSS-REFERENCE TO RELATED APPLICATION

This application claims priority to Chinese patent application No. 202110755788.7, entitled "METHOD FOR MANUFACTURING TSV SAMPLE", filed with the China National Intellectual Property Administration on July 5, 2021, the disclosure of which is hereby incorporated by reference in its entirety.

### TECHNICAL FIELD

This disclosure relates to the technical field of manufacturing process of semiconductor devices, and in particular to a Through-Silicon Via (TSV) product, a TSV sample, and a method for manufacturing the same.

### BACKGROUND

With the development of packaging and integration technologies of the semiconductors, digging treatment or site cutting treatment is performed on the TSV sample by using a high beam current of a dual-beam Plasma Focused Ion Beam (PFIB) during manufacturing a TSV sample, to form the TSV sample to which a cross-section of a TSV is exposed.

In the related art, a PFIB may usually be used to perform digging treatment on a TSV sample during cutting the TSV sample, to obtain a cross-section of the TSV sample, and various size parameters of the TSV sample are measured by using the cross-section. However, when the cross-section of the TSV sample is obtained in this manner in the related art, curtain-like draw marks may be formed at the cross-section during cutting to obtain the cross-section, due to a differences between cutting rates. That is, a curtain effect may occur. Relatively large errors are caused in the measurement of size parameters of the cross-section at which such a curtain effect occurs. In addition, a tungsten layer is usually plated on a surface of the TSV sample to prevent the curtain effect. However, the tungsten layer becomes thinner during cutting using an ion beam (I-Beam). As a result, the obtained cross-section recesses under the irradiation of the I-Beam, which also causes relatively large errors during measurement.

### SUMMARY

The embodiments of this disclosure provide a TSV product, a TSV sample, and a method for manufacturing the same, thereby improving the accuracy of measuring size parameters of TSVs.

The technical solutions provided in the embodiments of this disclosure include a method for manufacturing a TSV sample, a TSV sample, and a TSV product.

The method for manufacturing a TSV sample includes operations as follows.

A first metal layer is deposited on a bottom of each of the TSVs, and the first metal layer covers the bottom of the TSV

Pre-prepared adhesive is filled on an inner wall in the middle of each of the TSVs of a to-be-processed sample.

A second metal layer is deposited on the top of each of the TSVs, and the second metal layer covers on the top of an opening of the TSV

A capping layer is deposited on the second metal layer, to obtain a preprocessed to-be-processed sample.

The pre-processed to-be-processed sample is cut in a preset cutting manner by using a dual-beam Plasma Focused Ion Beam (PFIB), to form a TSV sample to which a cross-section of each of the TSVs is exposed.

The TSV sample is provided. The TSV sample includes TSVs, a first metal layer covering the bottom of each of the TSVs, a second metal layer deposited on the top of each of the TSVs, a capping layer deposited on the second metal layer, and an adhesive filled on an inner wall in the middle of each of the TSVs. The adhesive is in a solidified state.

The TSV product is provided. The TSV product is a product manufactured by using the foregoing method for manufacturing a TSV sample.

In the embodiments of this disclosure, first, a first metal layer is deposited on the bottom of each of the TSVs, the first metal layer covers the bottom, a pre-prepared adhesive is filled on an inner wall in the middle of each of the TSVs of a to-be-processed sample, then a second metal layer is deposited on the first metal layer of each of the TSVs, a capping layer is deposited on the second metal layer, to obtain a preprocessed to-be-processed sample. The preprocessed to-be-processed sample is cut in a preset cutting manner by using a PFIB, to form a TSV sample to which a cross-section of each of the TSVs is exposed. In this way, the adhesive is used to fill each of the TSVs of the to-be-processed sample, so that the inner wall in the middle of the TSV is filled. Therefore, during the cutting of the to-be-processed sample, the solidified adhesive has been filled in each of the TSVs. Therefore, the obtained TSV sample is in a fixed state. When the PFIB is used to cut the preprocessed to-be-processed sample, a curtain effect does not occur, thereby ensuring the accuracy of measured size parameters. In addition, in the embodiments of this disclosure, the capping layer is deposited on the second metal layer on an upper surface of each of the TSVs. Therefore, in a process of cutting the TSV sample by using the PFIB, the second metal layer can be prevented from being removed under irradiation, thereby ensuring that a recess problem on a site surface of the TSV sample caused by the irradiation of an I-Beam does not occur at a cross-section of the TSV sample. Therefore, in the embodiments of this disclosure, the adhesive is used to fill each of the TSVs, and the capping layer is deposited on the upper surface, to reduce an error caused by a curtain effect during cutting and measurement of a TSV sample, thereby improving the accuracy of measuring size parameters of the TSVs.

### BRIEF DESCRIPTION OF THE DRAWINGS

To describe the technical solutions in the embodiments of this disclosure or the prior art more clearly, the accompanying drawings required for describing the embodiments are described simply. Apparently, the accompanying drawings in the following description only shows some embodiments of this disclosure, and other drawings can also be obtained by those skilled in the art from these accompanying drawings without creative efforts.
FIG. 1 is a schematic diagram of a curtain effect;
FIG. 2 is a schematic diagram of a recessed site surface of a TSV sample;
FIG. 3 is a schematic structural diagram of a TSV sample in the related art;
FIG. 4 is a flowchart of a method for manufacturing a TSV sample according to an embodiment of this disclosure;
FIG. 5 is a schematic diagram of a TSV filling effect according to an embodiment of this disclosure; and
FIG. 6 is a schematic structural diagram of a TSV sample according to an embodiment of this disclosure.

### DETAILED DESCRIPTION

The technical solutions in the embodiments of this disclosure are clearly and completely described with reference to the accompanying drawings in the embodiments of this disclosure. Apparently, the described embodiments are only some rather than all of the embodiments of this disclosure. All other embodiments obtained by persons of ordinary skill in the art based on the embodiments of this disclosure without creative efforts fall within the protection scope of this disclosure.

At present, with the development of packaging and integration technologies of the semiconductors, because one TSV sample has a thickness of 50µm, a dual-beam plasma focused ion beam (PFIB) is required to perform digging on the TSV sample or perform cutting on a site surface of the TSV sample during analysis of a structure of a TSV sample, to obtain the TSV sample including a cross-section of the TSV

In the related art, to obtain a TSV sample including a cross-section, a PFIB may usually be used to perform digging treatment on the TSV sample or perform cutting on a site surface of the TSV sample to obtain the cross-section of the TSV sample. Each of the TSVs in the cross-section is measured, to obtain various size parameters of the TSV sample.

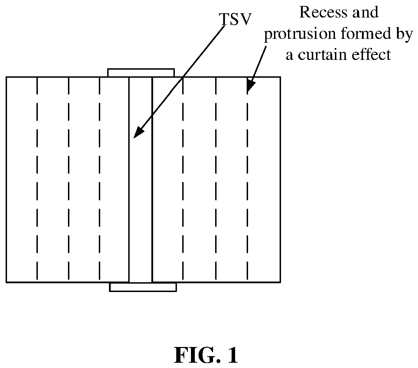

However, when the cross-section of the TSV sample is obtained in this manner in the related art, due to a difference in cutting rates, curtain-like draw marks may be formed at the cross-section. That is, a curtain effect occurs. In addition, the TSV sample usually has a thickness of 50 µm. When a high beam current of the PFIB is used to perform cutting on the TSV sample of the excess thickness to obtain the cross-section, a curtain effect also occurs at the cross-section. For example, FIG. 1 is a schematic diagram of a curtain effect. Due to the curtain effect, recesses or protrusions appear in the TSV sample. Therefore, relatively large errors are generated in the measurement of the cross-section at which such a curtain effect occurs.

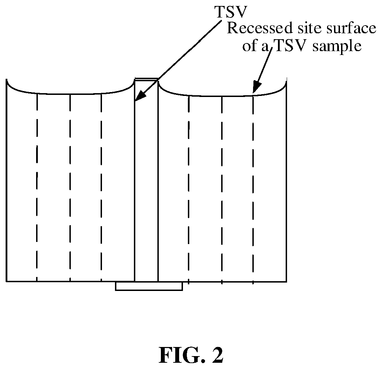

In addition, in the related art, to improve a problem of depression of a site surface of a TSV sample caused by the irradiation of an I-Beam on the TSV sample when the PFIB is used to cut the TSV sample, a tungsten layer is usually plated on a surface of the TSV sample to prevent a curtain effect. However, during cutting using an I-Beam of the PFIB, the tungsten layer becomes thinner. As a result, under the irradiation of the I-Beam, the site surface of the obtained TSV sample recesses. FIG. 2 is a schematic diagram of a recessed site surface of a TSV sample. As a result, relatively large errors may also generated in measurement.

To resolve the foregoing problem, in the embodiments of this disclosure, a method for manufacturing a TSV sample is provided. A first metal layer is deposited on the bottom of each of TSVs, and the first metal layer covers the bottom. A pre-prepared adhesive is filled on an inner wall in the middle of each of the TSVs of a to-be-processed sample. A second metal layer is deposited on the first metal layer of each of the TSVs. A capping layer is deposited on the second metal layer, to obtain a preprocessed to-be-processed sample. The preprocessed to-be-processed sample is cut in a preset cutting manner by using a PFIB, to form a TSV sample to which a cross-section of each of the TSVs is exposed. In this way, the pre-prepared adhesive is filled on the inner wall in the middle of each of the TSVs of the to-be-processed sample, so that the TSVs can be in a fixed state. Therefore, when the PFIB is used to cut the preprocessed to-be-processed sample, a curtain effect can be prevented because the TSVs are in a fixed state. In addition, in the embodiments of this disclosure, the capping layer is deposited on the second metal layer of an upper surface of each of the TSVs. When the PFIB is used to cut the preprocessed to-be-processed sample, the capping layer can protect the second metal layer from being damaged by the PFIB, thereby avoiding a site surface of the TSV sample from recessing. During the measurement of various size parameters of the TSV sample, the accuracy of measurement can be improved.

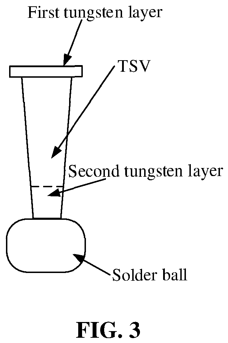

Based on the foregoing embodiments, the structure of a TSV sample in the related art is described below. FIG. 3 is a schematic structural diagram of a TSV sample in the related art. The TSV sample includes a first tungsten layer, TSVs, a second tungsten layer and solder balls.

In the related art, a layer of tungsten metal is plated on the upper surface of the TSV sample, to form the first tungsten layer. The first tungsten layer is arranged on the upper surface of the TSV sample, for preventing a site surface of the TSV sample from recessing.

In the related art, each of the TSVs in the TSV sample is hollow inside.

In the related art, the second tungsten layer is plated on the bottom of the TSV sample. That is, the tungsten layers are plated on both the upper surface and the bottom of each of the TSVs.

In the related art, the solder ball is located under the second tungsten layer at the bottom of the TSV

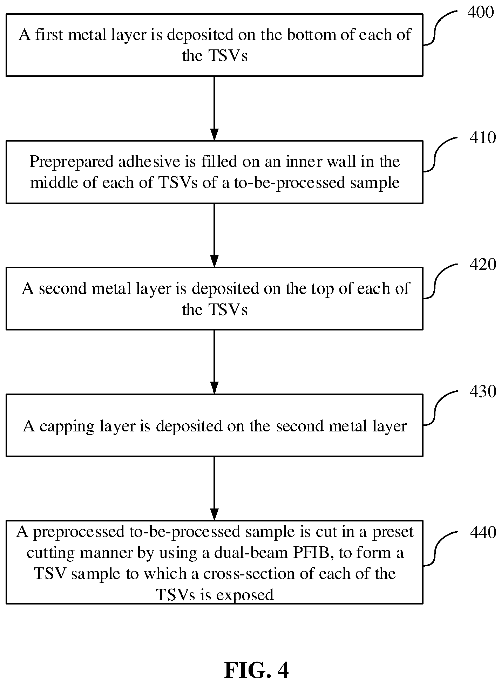

Based on the foregoing embodiment, FIG. 4 is a flowchart of a method for manufacturing a TSV sample according to an embodiment of this disclosure. The method includes the following operations.

At 400, a first metal layer is deposited on the bottom of each of the TSVs.

The first metal layer covers the bottom of the TSV

In the embodiments of this disclosure, the first metal layer is deposited at a bottommost portion of each of the TSVs, and the first metal layer covers the bottom of the TSV In addition, the bottom of each of the TSVs is connected to a metal contact structure. The metal contact structure in the embodiments of this disclosure is tin.

At 410, a pre-prepared adhesive is filled on an inner wall in the middle of each of the TSVs of a to-be-processed sample.

Specifically, first, the adhesive is prepared in a preset preparation manner. The preparation manner of the adhesive in the embodiment of this disclosure is described below in detail.

The preparation manner includes dissolving a catalyst and a curing agent in resin glue according to a preset mass ratio to form the adhesive. The mass ratio represents a ratio of mass of the catalyst to the curing agent.

In the embodiments of this disclosure, a mass ratio of the catalyst to the curing agent is determined first, and then the catalyst and the curing agent are dissolved in the resin glue according to the determined mass ratio, to form the bonding.

The curing agent is used for accelerating a speed at which the adhesive is solidified from a liquid state into a solid state, so that the adhesive can completely fill the TSVs. The catalyst is used for accelerating a chemical reaction between the curing agent and the resin glue, so that the prepared adhesive can be solidified faster.

It needs to be noted that, the resin glue in the embodiments of this disclosure may be, for example, an ion-milled resin. The ion-milled resin is a high-performance bicomponent epoxy phenol resin. The ion-milled resin has high adhesion, a uniform section face, and adequate chemical resistance and is non-conductivity. In addition, because the resin has adequate flow ability and is very suitable for bonding surfaces of two samples in a process of manufacturing a sectional surface sample. In addition, the ion-milled resin has a relatively high working temperature, and can withstand a heating condition during grinding and polishing and ion milling of a TSV sample. When the resin glue is the ion-milled resin, it is suitable for use in a vacuum environment. In addition, the ion-milled resin is suitable for bonding a strain gauge and a temperature sensor.

In addition, it needs to be noted that, the mass ratio in the embodiments of this disclosure may be set according to an actual requirement. In a possible implementation provided in the embodiments of this disclosure, the mass of the catalyst is the same as the mass of the curing agent. That is, the mass ratio of the catalyst dissolved in the resin glue to the mass of the curing agent dissolved in the resin glue is 1: 1. Certainly, another mass ratio may also be used, which is not limited in the embodiments of this disclosure.

Then, after the mass ratio of the catalyst to the curing agent is obtained, the pre-prepared adhesive is filled in a preset filling manner on the inner wall of each of the TSVs of the to-be-processed sample, so that each of the TSVs are in a filled state.

When the adhesive is filled on the inner wall in the middle of the each of TSVs in the preset filling manner, in a possible implementation provided in the embodiments of this resin glue, the adhesive is directly dripped on the inner wall in the middle of each of the TSVs.

Further, another possible implementation is provided in the embodiment of the disclosure for filling the adhesive to the inner wall in the middle of each of the TSVs in the preset filling manner. The implementation includes operations S1 and S2.

At S1, the adhesive is used to perform reciprocating coating on each of the TSVs, to enable the adhesive to uniformly cover the inner wall in the middle of each of the TSVs.

In the embodiments of this disclosure, a dropper is used to suck an appropriate amount of adhesive from the prepared adhesive, and drips the adhesive at edges in an opening direction of each of the TSVs. In this case, the liquid adhesive flows into the inner wall in the middle of each of the TSVs. Then, a brush or another tool is used to perform reciprocating coating on the adhesive bonded to the inner wall in the middle of the TSV, so that the adhesive uniformly covers the inner wall in the middle of the TSV

At S2, thermal treatment is performed on each of the TSVs, to enable the adhesive to be solidified and wrapped on the inner wall in the middle of each of the TSVs.

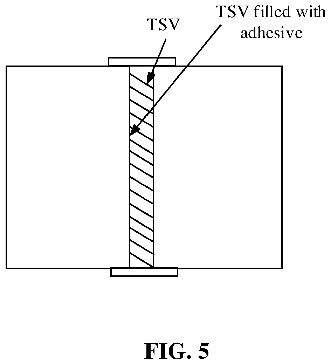

In the embodiments of this disclosure, each of the TSVs is heated, to enable the curing agent and the catalyst in the adhesive to react quickly, so that the adhesive that uniformly covers the inner wall in the middle of each of the TSVs is solidified from a liquid state into a solid state and is wrapped on the inner wall in the middle of each of the TSVs. FIG. 5 is a schematic diagram of a filling effect of the TSV according to an embodiment of this disclosure.

A heating temperature and a heating duration of the thermal treatment may be adjusted in real time according to a solidification degree of the adhesive. The heating temperature of the thermal treatment ranges from 60°C to 100°C. The heating duration of the thermal treatment ranges from 10 minutes to 20 minutes. For example, if the resin glue in the embodiments of this disclosure is the ion-milled resin, during the thermal treatment, the heating temperature of the thermal treatment may be 80°C, which is not limited in the embodiments of this disclosure.

In a preferred implementation in the embodiments of this disclosure, the heating temperature of the thermal treatment is 80°C, and the heating duration of the thermal treatment is 15 minutes.

Certainly, the adhesive in each of the TSVs may be automatically changed from a liquid state into a solid state at the room temperature by using the curing agent and the catalyst without performing the thermal treatment on the TSV, which is not limited in the embodiments of this disclosure.

Further, in the embodiments of this disclosure, after the adhesive is dripped in the TSV, because the adhesive may be insufficient or the adhesive may be not uniformly filled in the TSV, the TSV fail to be completely filled. Therefore, to further prevent that a curtain effect from occurring in a process of cutting the TSV sample and acquire more accurate size parameters, in the embodiments of this disclosure, an appropriate amount of adhesive may be repeatedly dripped in the TSV, and the thermal treatment is performed on the TSV in which the adhesive is dripped, so that the inner wall in the middle of each of the TSVs is completely filled.

Further, it needs to be noted that, the method in the embodiments of this disclosure may further be applicable to a hollow TSV structure sample, a glass through via structure sample, a resin through via structure sample, or other through via structure samples in substrates of different materials used for three-dimensional semiconductor packaging technologies, which is not limited.

At 420, a second metal layer is deposited on the top of each of the TSVs.

The second metal layer covers on the top of an opening of the TSV

In the embodiments of this disclosure, first, the second metal layer covers at edges in an opening direction of each of the TSVs of the to-be-processed sample, and the second metal layer is connected to the edge of each of the TSVs, so that each of the TSVs can be covered by the second metal layer.

It needs to be noted that, in a possible implementation of the embodiments of this disclosure, the second metal layer completely covers the opening at the top of the TSV That is, the second metal layer covers the opening at the top of each of the TSVs, and completely covers at the top of the opening of each of the TSVs.

At 430, a capping layer is deposited on the second metal layer, to obtain a preprocessed to-be-processed sample.

In the embodiments of this disclosure, the capping layer is deposited on the second metal layer, and the capping layer covers the second metal layer, so that the second metal layer and the capping layer are connected to each other, to obtain the preprocessed to-be-processed sample.

The second metal layer covers the edges in the opening direction of each of the TSVs, and is connected to the edges of each of the TSVs, and the capping layer covers the second metal layer.

It should be noted that, in a possible implementation of the embodiments of this disclosure, the capping layer completely covers an upper surface of the second metal layer.

In the embodiments of this disclosure, a material of the first metal layer may include, for example, tungsten, and a material of the second metal layer may include, for example, tungsten. The material of the first metal layer may be the same as the material of the second metal layer. A material of the capping layer includes silicon. A thickness of the first metal layer may be the same as a thickness of the second metal layer. Certainly, the thickness of the first metal layer may be greater than the thickness of the second metal layer, which is not limited in the embodiments of this disclosure.

Further, a size of the second metal layer may be, for example: x = 37.5µm, y = 12.5µm, and z = 5µm. A size of the capping layer may be, for example: x = 37.5µm, y = 12.5µm, and z = 20µm. x is a length of the capping layer, y is a width of the capping layer, and z is a deposition thickness of the capping layer.

It should be noted that, in the embodiments of this disclosure, a deposition thickness of the second metal layer is less than that of the capping layer. For example, the deposition thickness of the second metal layer is 5µm. The deposition thickness of the capping layer is 20µm. In this case, the deposition thickness of the second depositing layer is less than the deposition thickness of the cap layer.

In addition, the capping layer completely covers the upper surface of the second metal layer. That is, the size of the capping layer may be greater than or equal to the size of the second metal layer. In this way, under the irradiation of an I-Beam, the second metal layer under the capping layer can be prevented from being sacrificed under the irradiation of the I-Beam.

In addition, it needs to be noted that, in the embodiments of this disclosure, if the second metal layer is only plated on a site surface of the TSV sample, when an I-Beam of a PFIB is used to cut the preprocessed to-be-processed sample, the plated second metal layer is cut thinner. Therefore, under the irradiation of the I-Beam, the remaining second metal layer is sacrificed very quickly. In this case, after the PFIB sample is obtained through cutting, a recess problem occurs in the site surface of the TSV sample. To solve the problem and prevent the plated second metal layer from being sacrificed, the capping layer is deposited on the second metal layer. In this way, the second metal layer can be stopped from being sacrificed under the irradiation of the I-Beam.

At 440, the preprocessed to-be-processed sample is cut in a preset cutting manner by using a dual-beam PFIB, to form a TSV sample to which the cross-section of each of the TSVs is exposed.

In the embodiments of this disclosure, the preprocessed to-be-processed sample is cut in a dynamic cutting manner or a static cutting manner by using the PFIB, thereby, through cutting, obtaining the TSV sample to which the cross-section of each of the TSVs is exposed.

The cutting manner in the embodiments of this disclosure may include a first cutting manner and a second cutting manner. The first cutting manner is static cutting, and the second cutting manner is dynamic cutting. The two cutting manners in the embodiments of this disclosure are described below in detail.

The first cutting manner is the static cutting.

The cutting the preprocessed to-be-processed sample includes the following steps.

In S 1, a movement state of the preprocessed to-be-processed sample is set to a static state, and a movement state of the PFIB is also set to a static state.

In S2, the preprocessed to-be-processed sample is cut by using the PFIB according to a preset cutting angle.

In the embodiments of this disclosure, the preprocessed to-be-processed sample is directly cut by using the PFIB according to the preset cutting angle.

The second cutting manner is the dynamic cutting.

In the embodiments of this disclosure, when the cutting manner is the dynamic cutting, the following two cases are included according to the movement state of the preprocessed to-be-processed sample and the movement state of the PFIB.

In a first case, the movement state of the preprocessed to-be-processed sample is a static state, and the movement state of the PFIB is a swing movement state.

The first case includes the following steps.

In S 1, the movement state of the preprocessed to-be-processed sample is set to a static state, and the movement state of the PFIB is set to a swing movement state.

In the embodiments of this disclosure, the movement state of the preprocessed to-be-processed sample is set to a static state. That is, the to-be-processed sample does not move during cutting. In addition, the movement state of the PFIB is set to a swing movement state. That is, when the PFIB is used to cut the to-be-processed sample, the PFIB cut the preprocessed to-be-processed downwards in a movement direction of back-and-forth swing movement.

In S2, the preprocessed to-be-processed sample is cut by using the PFIB in a swing movement state according to a preset cutting angle.

In the embodiments of this disclosure, the cutting angle is first set, and then the to-be-processed sample in a static state is cut in a vertical direction by using the PFIB in a swing movement state at the preset cutting angle. After the cutting approaches a lower port of the TSVs, the cutting continues in a horizontal direction at the same cutting angle.

For example, assuming that the cutting angle is 5°, the to-be-processed sample in a static state is cut downwards by 8µm in the vertical direction by using the PFIB in a swing state at the cutting angle of 5°, and then the to-be processed sample is cut by 80µm in the horizontal direction at the same cutting angle of 5°, to eventually obtain the TSV sample with a length a width and a height, each of which is 80µm.

It should be noted that, the cutting angle in the embodiments of this disclosure may be determined according to an actual cutting case. For example, the cutting angle is ±5 degrees. In another example, the cutting angle is 10 degrees, which is not limited in the embodiments of this disclosure.

In addition, it should be noted that, a size of the TSV sample obtained through cutting in the embodiments of this disclosure may be, for example, x=80µm, y=80µm, and z=80µm, which is not limited in the embodiments of this application.

In the second case, the movement state of the preprocessed to-be-processed sample is a swing movement state, and the movement state of the PFIB is a static state.

In S 1, a movement state of the preprocessed to-be-processed sample is set to a swing movement state, and a movement state of the PFIB is set to a static state.

In the embodiments of this disclosure, the movement state of the preprocessed to-be-processed sample is set to a swing movement state. That is, the to-be-processed sample swings in a back-and-forth direction during cutting. In addition, the movement state of the PFIB is set to a static state. That is, when the PFIB cuts the to-be-processed sample, the PFIB does not swing in the back-and-forth direction, and only cuts the pre-processed to-be-processed sample downwards.

In S2, the pre-processed to-be-processed sample in the swing movement state is cut by using the PFIB according to a preset cutting angle.

In the embodiments of this disclosure, the cutting angle is first set. Then, the to-be-processed sample in a swing movement state is cut in the vertical direction by using the PFIB in a static state at the preset cutting angle. When the cutting approaches the lower port of the TSVs, the to-be processed sample is cut in the horizontal direction at the same cutting angle, to form the TSV sample to which the cross-section of each of the TSVs is exposed.

For example, assuming that the cutting angle is 10°, the to-be-processed sample in a swing movement state is cut downward by 40µm in the vertical direction at the cutting angle of 10° by using the PFIB in a static state, and then the to-be-processed sample is cut by 40 µm in the horizontal direction of the to-be-processed sample at the same cutting angle of 10°, to obtain the TSV sample with a length a width and a height, each of which is 40µm.

It should be noted that, in this case, the cutting angle may be ±5° or may be ±10°, which is not limited in the embodiments of this disclosure.

Further, in the embodiments of this disclosure, after the TSV sample is obtained through cutting, various size parameters of the TSV sample may be measured. The measurement includes: measuring the TSV sample, to obtain the various size parameters of the TSV sample.

In the embodiments of this disclosure, after the TSV sample is obtained through cutting, the various size parameters of the TSV sample can be measured, so that a height and size parameters of a side wall of each of the TSVs of the TSV sample may be obtained.

For example, the height of each of the TSVs and the size parameters of the via side wall of each of the TSVs, and a through via diameter of each of the TSVs may be measured.

In the embodiments of this disclosure, the adhesive is used to completely fill on the inner wall in the middle of each of the TSVs. In this way, when the TSV sample is cut by using the PFIB, a curtain effect is avoided from occurring on the side wall of the TSVs under the irradiation of an electronic beam of the PFIB, so that the accuracy of measurement can be improved. In addition, in the embodiments of this disclosure, on the basis that the second metal layer is plated on a upper surface of each of the TSVs, the capping layer is deposited on the second metal layer. In this way, the second metal layer is covered and blocked by the capping layer, to prevent the second metal layer from the irradiation of an I-Beam. Therefore, a recess is avoided from occurring on the site surface of the TSV sample after the second metal layer is milled and sacrificed since the I-Beam directly irradiates the surface of the second metal layer, thereby ensuring that a deformation problem does not occur in the TSV sample, and improving the accuracy of measuring various size parameters of each of the TSVs.

Based on the same inventive concept, an embodiment of the disclosure further provides a TSV product. The TSV product is manufactured by using the foregoing method for manufacturing a TSV sample according to the embodiments of this disclosure.

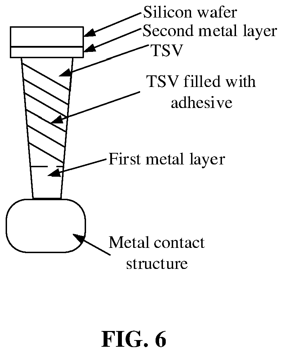

Based on the foregoing embodiments, the structure of a TSV sample in the embodiments of this disclosure is described below in detail. FIG. 6 is a schematic structural diagram of a TSV sample according to an embodiment of this disclosure. The TSV sample includes a metal contact structure, a first metal layer, TSVs, a second metal layer, and a capping layer.

In the embodiments of this disclosure, the metal contact structure is connected to an edge in a lower port direction of each of the TSVs, and is arranged in the lower port direction of each of the TSVs. The metal contact structure may be, for example, a solder ball. The solder ball is used to provide a base for supporting for the TSV

In the embodiments of this disclosure, the first metal layer covers the solder ball, and the first metal layer is bonded to the solder ball. In addition, the first metal layer is located at the bottom of each of the TSVs, and the first metal layer covers the bottom of the TSV A height of the first metal layer may be, for example, 10µm. A diameter of the first metal layer is the same as a diameter of the TSV

In the embodiments of this disclosure, the TSV include an adhesive filled on an inner wall in the middle of in each of the TSVs. The adhesive is in a solidified state, and completely covers the inner wall in the middle of each of the TSVs.

It should be noted that, the adhesive in the embodiments of this disclosure may be an M-Bond adhesive. For example, the M-Bond adhesive is filled in each of the TSVs in the embodiments of this disclosure. The M-Bond adhesive is completely filled in the TSV, so that a curtain effect during cutting a TSV sample using a PFIB can be solved.

In the embodiments of this disclosure, the second metal layer is plated at the edges in an opening direction of each of the TSVs. That is, the second metal layer covers at the edges in the opening direction of each of the TSVs, and is bonded to the edge of each of the TSVs. The second metal layer is deposited on the tops of each of the TSVs. The second metal layer completely covers the opening at the top of the TSV For example, a size of the second metal layer is: x = 37.5µm, y = 12.5µm, and z = 5µm. x is a length of the second metal layer, y is a width of the second metal layer, and z is a deposition thickness of the second metal layer.

In the embodiments of this disclosure, the capping layer is deposited on the second metal layer. A material of the cap layer includes silicon. That is, a silicon wafer covers the second metal layer, and the capping layer completely covers an upper surface of the second metal layer.

The silicon wafer is deposited on the second metal layer. A size of the silicon wafer may be the same as the size of the second metal layer. The size of the silicon wafer may further be greater than the size of the second metal layer. The deposition thickness of the second metal layer is less than that of the cap layer. For example, the size of the silicon wafer is: x=37.5µm, y=12.5µm, and z=20µm. x is a length of the silicon wafer, y is a width of the silicon wafer, and z is a deposition thickness of the silicon wafer.

Apparently, persons skilled in the art can make various modifications and variations to this disclosure without departing from the spirit and scope of this disclosure. In this way, if these modifications and variations to this disclosure fall within the scope of claims of this disclosure and equivalent technologies thereof, this disclosure also intends to cover these modifications and variations.

## Claims

1. A method for manufacturing a through-silicon via (TSV) sample, comprising:
depositing a first metal layer on a bottom of each of TSVs, the first metal layer covering the bottom of the TSV;
filling pre-prepared adhesive on an inner wall in a middle of each of TSVs of a to-be-processed sample;
depositing a second metal layer on a top of each of the TSVs, the second metal layer covering on a top of an opening of the TSV;
depositing a capping layer on the second metal layer, to obtain a preprocessed to-be-processed sample; and
cutting the preprocessed to-be-processed sample in a preset cutting manner by using a dual-beam Plasma Focused Ion Beam (PFIB), to form a TSV sample to which a cross-section of each of the TSVs is exposed.

2. The method according to claim 1, wherein the capping layer completely covers an upper surface of the second metal layer.

3. The method according to claim 1 or 2, wherein a deposition thickness of the second metal layer is less than that of the capping layer.

4. The method according to claim 1, wherein the second metal layer completely covers an upper opening of the TSV

5. The method according to claim 1, wherein the adhesive is configured by:
dissolving a catalyst and a curing agent in resin glue according to a preset mass ratio, to form the adhesive, wherein the mass ratio represents a ratio of mass of the catalyst to the curing agent.

6. The method according to claim 5, wherein the mass ratio of the catalyst to the curing agent is 1:1.

7. The method according to claim 1, wherein the filling pre-prepared adhesive on the inner wall in the middle of each of TSVs of the to-be-processed sample comprises:
performing reciprocating coating on each of the TSVs by using the adhesive, to enable the adhesive to uniformly cover the inner wall in the middle of each of the TSVs; and
performing thermal treatment on each of the TSVs, to enable the adhesive to be solidified and wrapped on the inner wall in the middle of each of the TSVs.

8. The method according to claim 7, wherein process parameters of the thermal treatment comprise: a temperature ranging from 60°C to 100°C, and a duration of the thermal treatment ranging from 10 minutes to 20 minutes.

9. The method according to claim 1, wherein a material of the first metal layer is the same as a material of the second metal layer, and a material of the capping layer comprises silicon.

10. The method according to claim 1, wherein the cutting manner is dynamic cutting.

11. The method according to claim 10, wherein the cutting the preprocessed to-be-processed sample in the preset cutting manner comprises:
setting a movement state of the preprocessed to-be-processed sample to a static state, and setting a movement state of the PFIB to a swing movement state; and
cutting the preprocessed to-be-processed sample by using the PFIB in the swing movement state according to a preset cutting angle.

12. The method according to claim 10, wherein the cutting the preprocessed to-be-processed sample in a preset cutting manner comprises:
setting a movement state of the preprocessed to-be-processed sample to a swing movement state, and setting a movement state of the PFIB to a static state; and
cutting the preprocessed to-be-processed sample in the swing movement state by using the PFIB according to a preset cutting angle.

13. The method according to claim 11 or 12, wherein the cutting angle is ±5 degrees, or the cutting angle is 10 degrees.

14. The method according to claim 1, after the TSV sample to which the cross-section of each of the TSVs is exposed is formed, further comprising:
measuring the TSV sample, to obtain various size parameters of the TSV sample.

15. A through-silicon via (TSV) sample, wherein the TSV sample comprises TSVs, a first metal layer covering on a bottom of each of the TSVs, a second metal layer deposited on a top of each of the TSVs, a capping layer deposited on the second metal layer, and adhesive filled on an inner wall in a middle of each of the TSVs, the adhesive being in a solidified state.

16. A through-silicon via (TSV) product, wherein the TSV product is a product manufactured by using the method according to any one of claims 1 to 14.
